# EUROPEAN PATENT SPECIFICATION

(11) **EP 0 685 849 B1**
(45) Date of publication and mention of the grant of the patent: **19.12.2001**
(21) Application number: 95400726.6
(22) Date of filing: 31.03.1995
(51) Int. Cl.: G11C 11/14

(54) **Storage device**
Speicheranordnung
Dispositif d'emmagasinage

(30) Priority: 27.05.1994 JP 11556494
(43) Date of publication of application: 06.12.1995
(73) Proprietor: FUJITSU LIMITED, Kawasaki-shi, Kanagawa 211 (JP)
(72) Inventor: Kouhei, Tohru, c/o Fujitsu Limited, Kawasaki-shi, Kanagawa, 211 (JP); Kikuchi, Hideyuki, c/o Fujitsu Limited, Kawasaki-shi, Kanagawa, 211 (JP)
(74) Representative: Joly, Jean-Jacques

(56) References cited:
- US-A- 5 173 873
- BROWN J L ET AL: "1-MB MEMORY CHIP USING GIANT MAGNETORESISTIVE MEMORY CELLS" IEEE TRANSACTIONS ON COMPONENTS, PACKAGING AND MANUFACTURING TECHNOLOGY: PART A, vol. 17, no. 3, 1 September 1994, pages 373-379, XP000462470

## Description

### BACKGROUND OF THE INVENTION

### Field of the Invention

The present invention generally relates to a storage device for storing binary data and, more particularly, to a storage device equipped with a magnetoresistive element presenting hysteresis characteristics in the relationship between a magnetic field and a volume resistivity change rate (MR ratio).

### Description of the Related Art

In the field of computers and communication systems which deal with digital data, storage devices for storing binary data are required. Such a storage device is so constituted as to retain either temporarily or permanently the difference of some physical states such as magnetic ones.

In the conventional storage devices known heretofore, there is a type capable of storing data in accordance with the presence or absence of electric charge accumulated in a capacitor, as represented by a dynamic random access memory (DRAM). However, a DRAM has a disadvantage that the data stored therein is lost unless an overwrite operation termed refresh is performed continuously. That is, there exists a problem of nonvolatility.

Any of magnetic recording apparatus represented by a magnetic disk apparatus is nonvolatile, since data is recorded by changing the direction of magnetization of a magnetic substance. But a rotary mechanism, a read/write head positioning mechanism and so forth are necessary therein, and a long time is taken for positioning the head and transferring the data. Consequently, a considerable time is required for writing and reading the data.

A flash memory is known as a nonvolatile semiconductor storage device. Since an overwrite operation is impossible in a flash memory, it is necessary to perform an erase operation first and then a write operation, hence inducing a disadvantage that this type is not suited for high-speed repetitive recording purpose. And the ensured number of times of writing is no more than 1 × 10⁵ or so.

In Japanese Patent Laid-open Nos. Hei 1 (1989)-178190, Hei 1 (1989)-178191 and Sho 61 (1986)-153897, there is disclosed a method of recording data on a magnetic medium by causing a current flow in intersecting striped superconductors, and detecting the direction of magnetization by adjacent magnetoresistive elements. However, in this method where superconductors are required, there exist some problems including that it is unemployable at normal temperature, and the production cost of the apparatus is increased. Furthermore, there is another disadvantage that both a recording magnetic medium and reading magnetoresistive elements need to be prepared.

In the thesis titled Magnetic Thin Film (by Miyazaki, Tohoku University), there is described a testing method according to which a thin film is interposed between mutually orthogonal conductors via insulator layers, and the magnetic characteristic of the thin film is measured by a tunnel current detection means. Although this method is capable of realizing a device of a simplified structure, it is difficult to apply the method to a practical recorder since the change range of the resistance value is excessively small due to utilization of the tunnel current. In addition, the magnetic field generation efficiency to the current is low as the magnetic field of the orthogonal lines is utilized directly.

A storage device as indicated in the preamble of claim 1 is known from US-A-5 173 873. In this storage device, reading is performed without applying a bias magnetic field.

A further similar storage device is known from BROWN J L ET AL: "1-MB MEMORY CHIP USING GIANT MAGNETORESISTIVE MEMORY CELLS" IEEE TRANSACTIONS ON COMPONENTS, PACKAGING AND MANUFACTURING TECHNOLOGY: PART A, vol. 17, no: 3, 1 September 1994, pages 373-379, XP000462470. In this storage device, the writing operation and the reading operation each is performed by applying two magnetic fields orthogonally orientated to each other.

### SUMMARY OF THE INVENTION

It is therefore an object of the present invention to provide a high-reliability nonvolatile storage device of a simplified structure which is usable in a normal temperature range and is adequate to reduce the time required for writing, reading or overwriting data.

According to one aspect of this invention, there is provided a storage device which comprises: a magnetoresistive element presenting hysteresis characteristics in the relationship between a magnetic field and a volume resistivity change rate; write means for applying, in response to input binary storage data indicative of either a first state or a second state, a write magnetic field of a predetermined intensity in a first direction to the magnetoresistive element correspondingly to the first state, or applying the write magnetic field in a second direction, which is reverse to the first direction, to the magnetoresistive element correspondingly to the second state; and read means for applying to the magnetoresistive element a bias magnetic field which is lower in intensity than the write magnetic field, and discriminating between the first and second states on the basis of the volume resistivity change rate of the magnetoresistive element.

When binary storage data indicative of either a first state or a second state is inputted to the device of this invention, a write magnetic field is applied to the magnetoresistive element in one of mutually reverse directions correspondingly to the first state or the second state. Then, even after extinction of the write magnetic field, the stored data is retained by the hysteresis characteristics of the magnetoresistive element.

In reading out the stored data, a bias magnetic field lower in intensity than the write magnetic field is applied to the magnetoresistive element, and the first or second state is discriminated in accordance with the volume resistivity change rate of the magnetoresistive element.

The objects, features and advantages of the present invention and the manner of realizing them will become more apparent, and the invention itself will best be understood from a study of the following description and appended claims with reference to the attached drawings showing some preferred embodiments of the invention.

### BRIEF DESCRIPTION OF THE DRAWINGS

Fig. 1 is a perspective view of a storage device in a first embodiment of the present invention;
Fig. 2 is a sectional view taken along the line A-A in the device of Fig. 1;
Fig. 3 is a perspective view of an MR element;
Fig. 4A and Fig. 4B are explanatory diagrams illustrating the directions of magnetization;
Fig. 5 graphically shows the principle of operation of a storage device;
Fig. 6 is a block diagram of a write/read circuit;
Fig. 7 graphically illustrates demagnetization of an MR element;
Fig. 8 is a perspective view of a storage device in a second embodiment of the present invention;
Fig. 9 is a perspective view of a storage device in a third embodiment of the present invention;
Fig. 10A and Fig. 10B illustrate packaged examples having the structure of Fig. 9;
Fig. 11 is a perspective view of a memory card to which the present invention is applicable;
Fig. 12 graphically shows the characteristic of a GMR element;
Fig. 13 is a perspective view of the GMR element;
Fig. 14 graphically illustrates the principle of operation of the GMR element; and
Fig. 15A and Fig. 15B are perspective views of SOP and SOJ, respectively, with partly broken away to show some components.

### DESCRIPTION OF THE PREFERRED EMBODIMENTS

Hereinafter some preferred embodiments of the present invention will be described in detail with reference to the accompanying drawings.

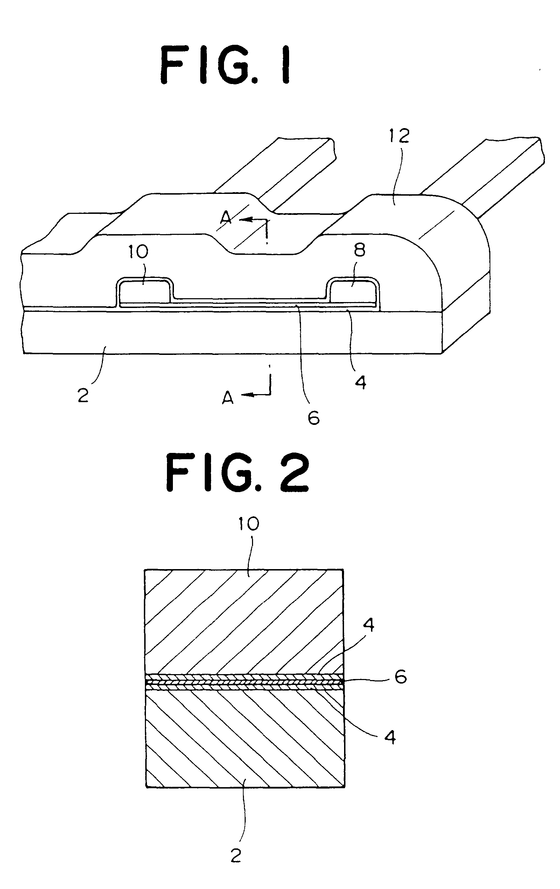

Fig. 1 is a perspective view of a storage device in a first embodiment of the invention, and Fig. 2 is a sectional view taken along the line A-A in Fig. 1. Reference numeral 2 denotes a lower current line formed on an unshown substrate, and a magnetoresistive element (MR element) 6 is provided on the lower current line 2 via insulator layers 4. The MR element 6 may be a film formed by vapor deposition of NiFe for example. Terminals 8 and 10 are connected to both ends of the MR element 6, and an upper current line 12 is provided in such a manner as to surround the MR element 6 and the terminals 8 and 10.

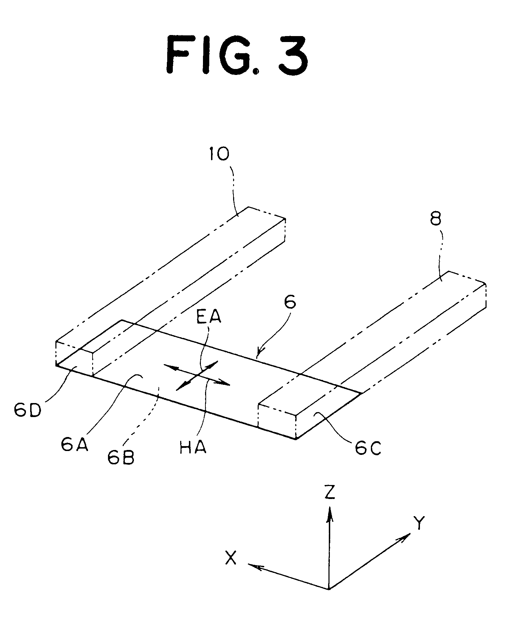

Fig. 3 is a perspective view of the MR element shown in Fig. 1. The MR element 6 is shaped into, e.g., a rectangular thin film having a hard axis HA of magnetization in its longitudinal direction and an easy axis EA of magnetization in its transverse direction. Further the MR element 6 has a first plane 6A and a second plane 6B corresponding respectively to its obverse side and reverse side, and a first end portion 6C and a second end portion 6D corresponding respectively to both ends of its longitudinal direction. On the first plane 6A, the terminals 8 and 10 are connected respectively to the first end portion 6C and the second end portion 6D of the MR element. The upper current line 12 and the lower current line 2 are opposed respectively to the first plane 6A and the second plane 6B of the MR element 6. For the purpose of serving convenience in the following description, there are defined here an X axis parallel with the hard axis HA of magnetization, a Y axis parallel with the easy axis EA of magnetization, and a Z axis perpendicular to the X axis and Y axis. In the X axis, the direction advancing from the first end portion 6C toward the second end portion 6D is defined as a +X direction, and the direction reverse thereto is defined as a -X direction. Meanwhile in the Y axis, the direction to lead out the terminals 8 and 10 is defined as a +Y direction, and the direction reverse thereto is defined as a -Y direction. And in the Z axis, the direction advancing from the second plane 6B toward the first plane 6A is defined as a +Z direction, and the direction reverse thereto is defined as a -Z direction.

In the first embodiment, write means includes a lower current lines 2 and an upper current line 12, means for causing a write current flow in the current lines 2 and 12 in mutually reverse directions, and means for deciding the direction of the write current flow correspondingly to the first or second state of the storage data. The first and second states correspond respectively to, e.g., 1 and 0 of digital data. In the following description, it is assumed that the first state corresponds to 1 and the second state to 0, respectively.

For causing a write current flow in the lower current line 2 and the upper current line 12 in mutually reverse directions, this embodiment is so contrived that one end portion of the upper current line 12 in the -X direction is connected to one end portion of the lower current line 2 in the same direction, whereby a single-turn coil is formed around the MR element 6. More specifically, the current lines 2 and 12 are connected in series to each other. It is to be understood that a coil of plural turns may be formed as well. The means for deciding the direction of the write current flow correspondingly to 1 or 0 comprises a constant current circuit having, e.g., two output ports, and a circuit for selectively switching the connection of each output port and the end portions of the current lines 2 and 12 in the +X direction correspondingly to 1 or 0. A specific example of the write/read circuit will be described later.

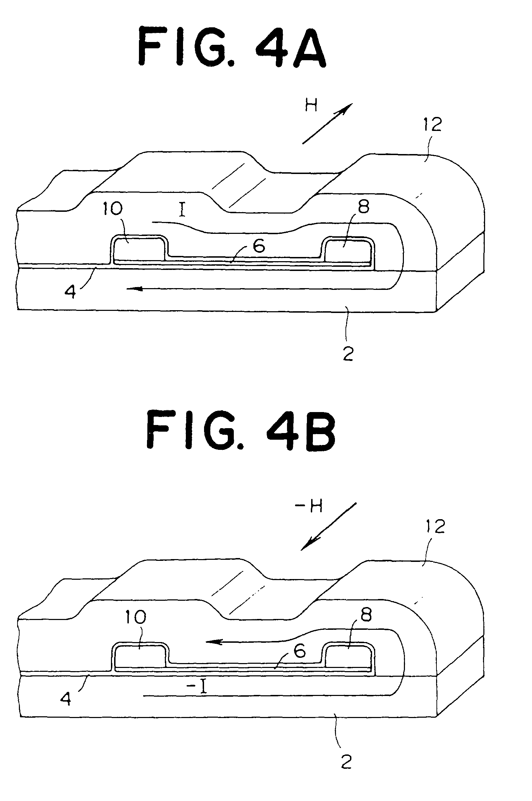

Fig. 4A and Fig. 4B show the directions of a magnetic field applied to the MR element 6 through the lower current line 2 and the upper current line 12. Fig. 4A represents one case where a current I is flowing from the upper current line 12 into the lower current line 2. In this case, the current flow in the upper current line 12 is in the -X direction, while the current flow in the lower current line 2 is in the +X direction. As a result, the magnetic field H is applied to the MR element 6 in the +Y direction substantially in parallel with the easy axis of magnetization. The intensity of a magnetic field H is given by the function of the current I. Fig. 4B represents another case where a current -I is flowing from the lower current line 2 into the upper current line 12. In this case, the current flow in the lower current line 2 is in the -X direction, while the current flow in the upper current line 12 is in the +X direction. As a result, a magnetic field -H is applied to the MR element 6 in the -Y direction substantially in parallel with the easy axis of magnetization. Thus, according to this embodiment where coiled current lines are provided around the MR element 6, a write magnetic field or a bias magnetic field of a desired strength can be applied in a desired direction.

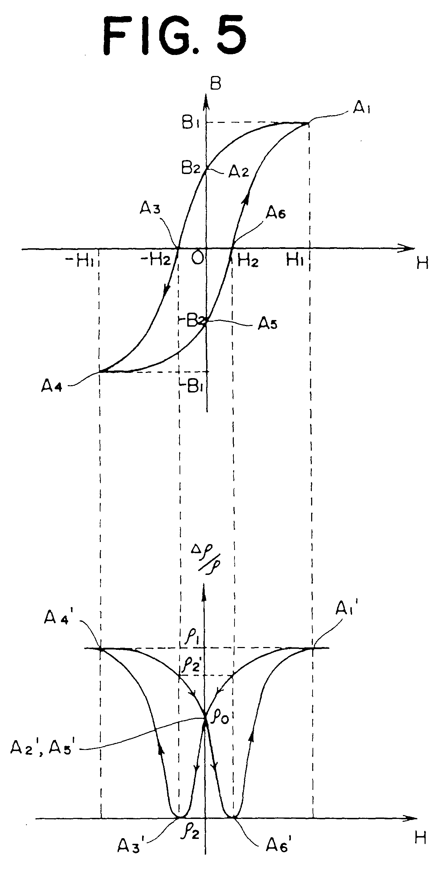

Fig. 5 shows the principle of operation of the storage device. In this diagram, the B-H characteristic graphed in the upper part represents the relationship between the magnetic flux density B in the easy axis of magnetization of the MR element and the magnetic field H applied thereto; and the Δρ/ρ-H characteristic graphed in the lower part represents the relationship between the volume resistivity change rate (MR ratio) Δρ/ρ of the MR element and the magnetic field H applied thereto. The applied magnetic field H in the B-H characteristic and the applied magnetic field H in the Δρ/ρ-H characteristic are shown on the same scale. In this specification, the terms magnetization and magnetic flux density are used in the same sense. The MR element presents hysteresis characteristic in the relationship between the magnetic field H and the magnetization B, hence presenting hysteresis characteristic also in the relationship between the magnetic field H and the MR ratio Δρ/ρ.

First, for storage of 1, a write current is caused to flow in the direction shown in Fig. 4A, and a magnetic field H₁, which is approximately equal in intensity to the magnetic field required for saturating the magnetization of the MR element, is applied to the MR element. The magnetization at this moment is B₁ as indicated at a point: A₁, and the MR ratio is ρ₁ as indicated at a point A₁'. When the write current is switched off, the magnetization is reduced to B₂ (B₂ < B₁) as indicated at a point A₂, and the MR ratio is lowered to ρ₀ (ρ₀ < ρ₁) as indicated at a point A₂', so that 1 is retained by the residual magnetization B₂.

Meanwhile for storage of 0, a write current is caused to flow in the direction shown in Fig. 4B, and a magnetic field -H₁, which is equal in intensity to the magnetic field H₁ but is directionally reverse thereto, is applied to the MR element. The magnetization at this moment is -B₁ as indicated at a point A₄, and the MR ratio is ρ₁ as indicated at a point A₄'. In the process of a transition from the point A₂ to the point A₄, the magnetization passes a point A₃ where the flux density is zero. The magnetic field at this moment is -H₂ (-H₁ < -H₂ < 0), and the MR ratio is ρ₂ (ρ₂ < ρ₀) as indicated at a point A₃'. When the write current corresponding to 0 is switched off, the magnetization is changed from -B₁ to -B₂ (-B₁ < -B₂ < 0), so that 0 is retained by such magnetization. The MR ratio at this moment is ρ₀ as indicated at a point A₅'.

For storage of 1 by overwriting it in the state where 0 is stored as indicated at a point A₅, the write magnetic field H₁ is applied again to the MR element to thereby transit the magnetization to the point A₁. In this process, the magnetization passes a point A₆ where the flux density is zero and the magnetic field is H₂ (0 < H₂ < H₁). The MR ratio corresponding to the point A₆ is ρ₂ as indicated at a point A₆'. When overwriting 1 at the point A₂ where 1 is presently stored, the write magnetic field H₁ is applied for transition of the magnetization from the point A₂ to the point A₁. Similarly, when overwriting 0 at the point A₅ where 0 is presently stored, the write magnetic field -H₁ is applied for transition of the magnetization from the point A₅ to the point A₄.

How to read out the stored data will now be described below. The directions (signs) of the retained magnetization in the 1 storage state (A₂) and the 0 storage state (A₅) are mutually different, but the MR ratio of the MR element is ρ₀ and the same in each case, so that it is impossible under such condition to read out the data stored in accordance with the difference of the MR ratio. Therefore, a bias magnetic field lower in intensity than the write magnetic field is applied to the MR element, and a discrimination between 1 and 0 is made depending on the numerical value of the MR ratio of the MR element at that time. The specific details are as follows.

In the example of Fig. 5, the bias magnetic field is set to H₂ or -H₂ which gives the minimum value ρ₂ of the MR ratio. In one case where the bias magnetic field is set to H₂, a bias current smaller than the write current is caused to flow in the direction shown in Fig. 4A. Meanwhile in the other case where the bias magnetic field is set to -H₂, the bias current is caused to flow in the direction shown in Fig. 4B. Suppose now that the bias current is set to H₂ for reading the stored data. When the stored data is 1, the MR ratio is increased from ρ₀ to ρ₂' (ρ₀ < ρ₂' < ρ₁) by the application of the bias magnetic field. And when the stored data is 0, the MR ratio is lowered from ρ₀ to ρ₂ by the application of the bias magnetic field. The stored data is read out in this manner. In the other case where the bias magnetic field is set to -H₂, the MR ratio is changed inversely to the above example. That is, when 1 is stored, the MR ratio is lowered from ρ₀ to ρ₂ by the application of the bias magnetic field; and when 0 is stored, the MR ratio is increased from ρ₀ to ρ₂' by the application of the bias magnetic field. The numerical value of the MR ratio can be discriminated by detecting the resistance value of the MR element 6 between the terminals 8 and 10 (see Fig. 1). This discrimination can be achieved by causing a flow of a resistance detection current between the terminals 8 and 10 and then detecting the voltage drop induced in the MR element 6.

This storage device is nonvolatile since data is stored therein by the direction (sign) of magnetization of the MR element, and it is usable at normal temperature. Moreover, the factor that limits the write and read speeds is merely the response of the magnetization to the applied magnetic field, so that the time required for writing, reading and overwriting the data can be minimized. In addition, it is possible to provide a high-reliability storage device of a simplified structure with simplified electric circuits as shown in Fig. 1. For the purpose of enhancing the read sensitivity, it is desired that the intensity of the write magnetic field is set to be approximately equal to or higher than the intensity of the magnetic field required for saturating the magnetization of the MR element. Also for the same purpose, it is desired that the bias magnetic field is so set as to maximize the difference between the MR ratio corresponding to 1 and that corresponding to 0 obtained when the bias magnetic field is applied to the MR element. Such bias magnetic field is in the extreme proximity of the point A₃' or A₆' in Fig. 5.

In the description given above, digital data 1 and 0 correspond respectively to the points A₁ and A₄ in Fig. 5. However, such correspondence may be reverse as well. In either case, if the direction of the residual magnetization based on the stored data and the direction of the bias magnetic field are mutually the same, the MR ratio is lowered by the application of the bias magnetic field. And if the direction of the residual magnetization based on the stored data and the direction of the bias magnetic field are mutually reverse, the MR ratio is increased by the application of the bias magnetic field.

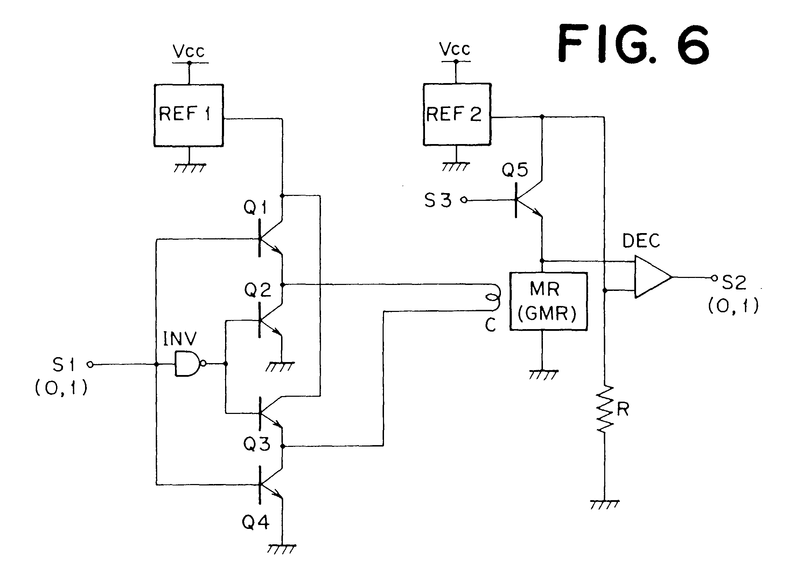

Hereinafter a specific example of a write/read circuit will be described with reference to Fig. 6. In this diagram, REF1 and REF2 stand for constant current sources; Q1, Q2, Q3, Q4 and Q5 for transistors; INV for an inverter; MR (GMR) for the aforementioned MR element 6 or an undermentioned giant magnetoresistive element; C for a coil formed by the current lines 2 and 12; DEC for a decider; R for a reference resistor; S1 for a write input signal; S2 for a read output signal; and S3 for a read enable signal, respectively.

A write circuit is connected to the coil C, and a read circuit is connected to the MR element. The output of the constant current source REF1 is supplied to respective collectors of the transistors Q1 and Q3. An emitter of the transistor Q1 and a collector of the transistor Q2 are connected to one end of the coil C (upper current line 12), while an emitter of the transistor Q3 and a collector of the transistor Q4 are connected to the other end of the coil C (lower current line 2). Emitters of the transistors Q2 and Q4 are grounded respectively. The write input signal S1 is supplied directly to bases of the transistors Q1 and Q4 while being supplied, after inversion via the inverter INV, to bases of the transistors Q2 and Q3.

The output of the constant current source REF2 is supplied to a collector of the transistor Q5, a first input port of the decider DEC and a first end of the reference resistor R. The read enable signal S3 is supplied to a base of the transistor Q5, and an emitter of the transistor Q5 is connected to both a first terminal of the MR element and a second input port of the decider DEC. A second terminal of the MR element and a second end of the reference resistor R are grounded. The read output signal S2 is delivered from an output port of the decider DEC. The decider DEC makes a decision as to whether the potential at the first terminal of the MR element is greater or not than the voltage drop across the reference resistor R.

When the write input signal S1 is 1 at a high level, the transistors Q1 and Q4 are turned on while the transistors Q2 and Q3 are turned off, so that the current from the constant current source REF1 flows in the coil C downward in the diagram. Contrary to the above, when the write input signal S1 is 0 at a low level, the transistors Q2 and Q3 are turned on while the transistors Q1 and Q4 are turned off, so that the current from the constant current source REF1 flows in the coil C upward. Therefore, the direction of the current flowing in the coil C can be selectively switched in conformity to the write input signal 1 or 0 by the use of such write circuit.

Upon supply of the read enable signal S3 to the transistor Q5 in the read circuit, the current from the constant current source REF2 flows in the MR element to serve as a bias current. Consequently, it is possible to read out the stored data from the MR element by comparing the voltage drop in the MR element with the voltage drop in the reference resistor R, hence obtaining an output signal S2.

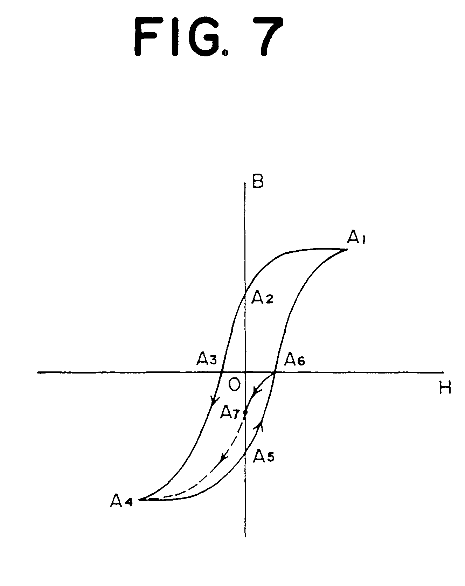

Fig. 7 graphically illustrates demagnetization of the MR element induced by the application of a bias magnetic field, and it corresponds to the graph of Fig. 5 showing the B-H characteristic. Assume now that a bias magnetic field is applied to the MR element at a point A₅ where data is stored, and subsequently the bias magnetic field is switched off after transition to a point A₆. Then the residual magnetization (residual magnetic flux) of the MR element is shifted toward the origin in the B-H characteristic as indicated at a point A₇. This phenomenon is termed demagnetization. Contrary to the above, no demagnetization is induced if the bias magnetic field is switched off after being applied in the same direction at a data-stored point A₂. Generally speaking, demagnetization is induced when the direction of the bias magnetic field is reverse to that of the magnetization based on the stored data. Upon occurrence of such demagnetization, it becomes difficult to read out the same stored data a plurality of times. In such a case, a magnetic field for writing the same data may be applied on the basis of the data read out by applying the bias magnetic field. Then it is rendered possible by this process to read out the same stored data a plurality of times.

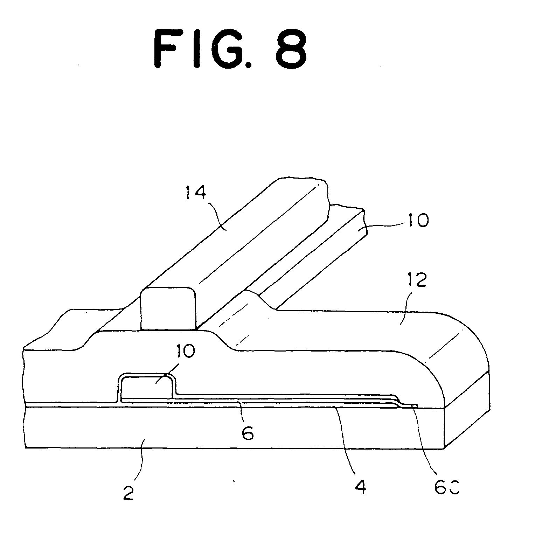

Fig. 8 is a perspective view of a storage device in a second embodiment of the present invention. In comparison with the foregoing first embodiment, the second embodiment is characterized in that the terminal 8 is omitted, and another terminal 14 is additionally provided. The terminal 14 is connected to the upper current line 12 at a position corresponding to the terminal 10. The MR element 6 is connected to the two current lines 2 and 12 in such a manner that the second end portion 6C thereof is sandwiched between the respective joints of the lower current line 2 and the upper current line 12. According to this embodiment, a resistance detection current for detecting the MR ratio of the MR element 6 can be caused to flow in the upper current line 12. More specifically, a current source for such resistance detection is connected between the terminals 10 and 14.

When the resistance detection current flows in the upper current line 12, a bias magnetic field can be applied to the MR element 6 by this current flow substantially in parallel with the easy axis of magnetization. Thus, it is possible in the second embodiment to use the resistance detection current also as a bias current, hence reducing the power consumption in reading the data. The terminal 14 can be omitted as well. In this case, the resistance detection current is caused to flow between the terminal 10 and one end of the upper current line 12 in the +X direction. Then the read terminal can serve also as a write current line to thereby enhance the packaging density in mounting a plurality of storage cells of this structure on a substrate. In case the terminal 14 is omitted, the resistance detection current may also be caused to flow between the terminal 10 and one end of the lower current line 2 in the +X direction.

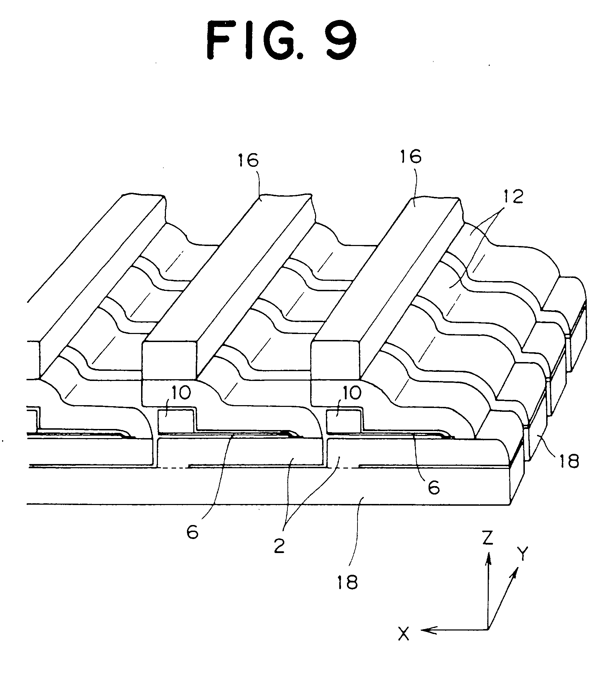

Fig. 9 is a perspective view of a storage device in a third embodiment of the present invention, wherein a multiplicity of cells each having the structure of Fig. 8 are arrayed in a manner to form a matrix. For arraying the MR elements in the form of a matrix, a plurality of bit lines 16 and a plurality of word lines 18 are arranged. The bit lines 16 are connected to a plurality of upper current lines 12 arranged in the Y-axis direction, while the word lines 18 are connected to a plurality of lower current lines 2 arranged in the X-axis direction. The terminal 10 shown in Fig. 8 is used in common for all the cells arrayed in the Y-axis direction. In this embodiment, the bit lines 16 correspond to the terminal 14 in Fig. 8. In a write mode, one storage cell can be selected by a combination of one bit line 16 and one word line 18. Also in a read mode, one storage cell can be selected by a combination of the terminal 10 and one word line 18.

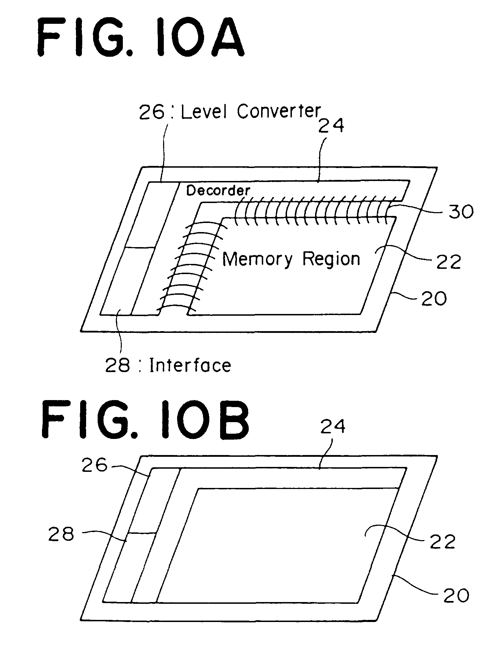

Fig. 10A and Fig. 10B illustrate packaged examples each having the structure of Fig. 9. In one example shown in Fig. 10A, a memory region 22 is formed on a substrate 20 by the structure of Fig. 8, and a decoder circuit 24, a level converter circuit 26 and an interface circuit 28 are formed in the vicinity of the memory region 22. The memory region 22 and the decoder circuit 24 are connected to each other by means of a bonding wire 30. In another example shown in Fig. 10B, the memory region 22 and the decoder circuit 24 are connected directly to each other by means of a thin-film conductor layer with omission of the bonding wire 30. The decoder circuit 24 serves to designate a desired address in the memory region 22, and the level converter circuit 26 serves to render the device of this invention interchangeable with the conventional known storage device. In addition to the component circuits described above, there may be further formed a write current control circuit and a read current control circuit on the substrate 20.

Next, an example of the recording density in the embodiment of Fig. 9 will be calculated below as a trial. Assume now that each line has a thickness of 3 µm and a width of 2 µm, the MR element has an effective length of 2 µm, and the write current is 30 mA. Under such conditions, the intensity of the write magnetic field is approximately 190 Oe (1 × 30 mA/2 µm = 15000 A/m = 188.4 Oe). And the resistance change rate at the application of a bias magnetic field of 30 Oe or so is approximately 15 percent. In an exemplary case where each storage cell has an area of 3 × 4 µm², the recording density is 83.25 Kbits/mm² (53.71 Mbits/in²).

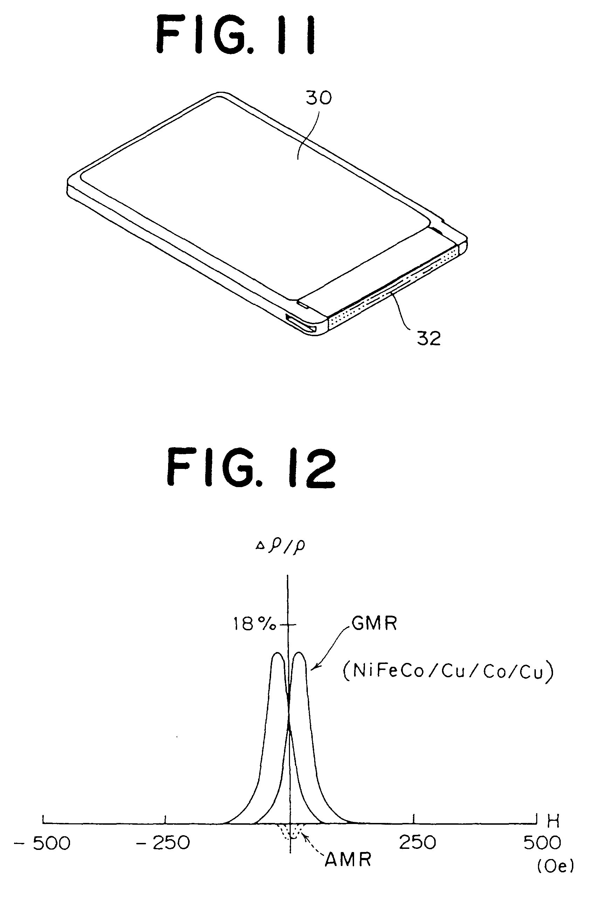

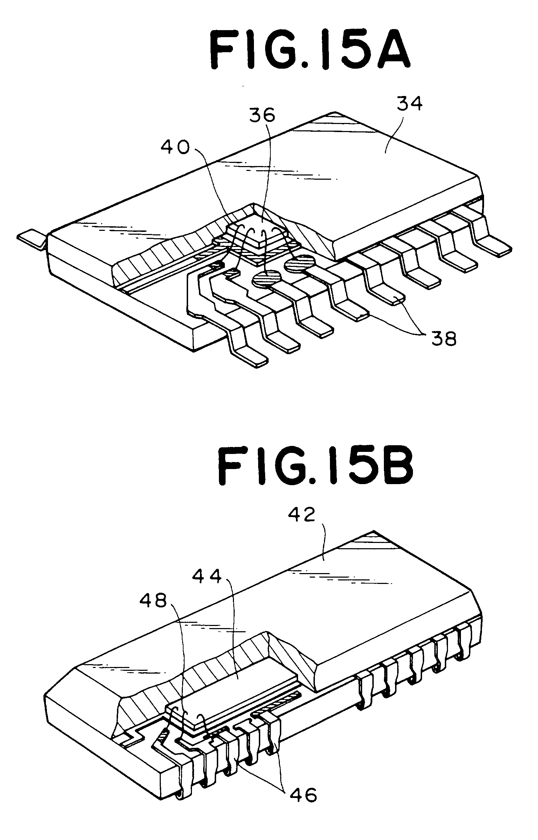

Fig. 11 is an exterior perspective view of a memory card to which the present invention is applicable. This memory card comprises a main body 30 where, e.g., the substrate 20 shown in Fig. 10A is incorporated, and a connector 32 for connection to an external circuit. For example, it is supposed to be an IC memory card size Type-1 prescribed by PCMCIA. Since this memory card has an area of 4505 mm² (85 mm × 53 mm), the area of its effective storage region, which is 80 percent of the entire area in this example, is approximately 3600 mm². Therefore, in a four-layer structure, the storage capacity amounts to 150 Mbytes at a recording density of 83.25 Kbits/mm². It is to be understood that the present invention is not limited to such a memory card alone and may also be applied to any plastic (resin) package similar to the conventional dynamic random access memory or static random access memory known heretofore (refer to Figs. 15A and 15B).

The MR element may be an ordinary anisotropic magnetoresistive element (AMR element), and a giant magnetoresistive element (GMR element) may be employed as well. A GMR element is characterized in that, since the directions of magnetizations are mutually unparallel on both sides of an insulator film, the attainable magnetoresistive effect is greater by one digit than that of an AMR element.

Fig. 12 graphically shows the characteristic of a GMR element which is composed of layers of, e.g., NiFeCo, Cu ,Co and Cu deposited successively in this order, wherein a symbol GMR denotes its characteristic curve. The MR ratio (Δρ/ρ) is taken along the ordinate, and the applied magnetic field is taken along the abscissa. For comparison, the characteristic curve of an AMR element is denoted by a symbol AMR. Thus, the GMR element has superior hysteresis characteristic in addition to its great magnetoresistive effect, hence capable of realizing a high S/N. Differing from the anisotropic magnetoresistive element described above, the GMR element has no distinction between an easy axis of magnetization and a hard axis of magnetization. Consequently, to the GMR element shaped into a thin film, both a write magnetic field and a bias magnetic field are applied substantially in parallel with the in-plane direction of the thin film.

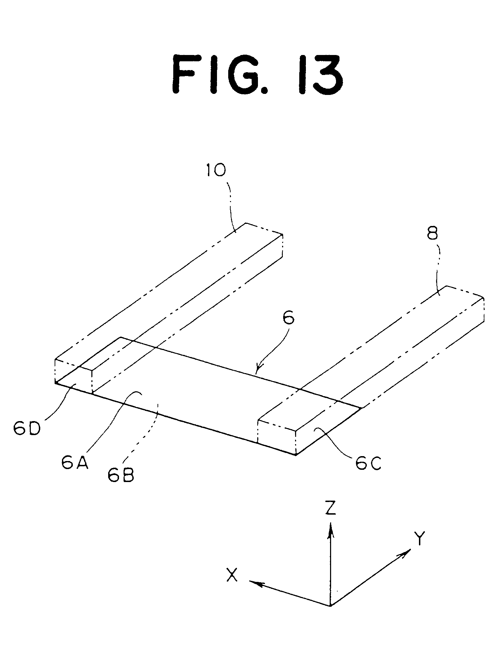

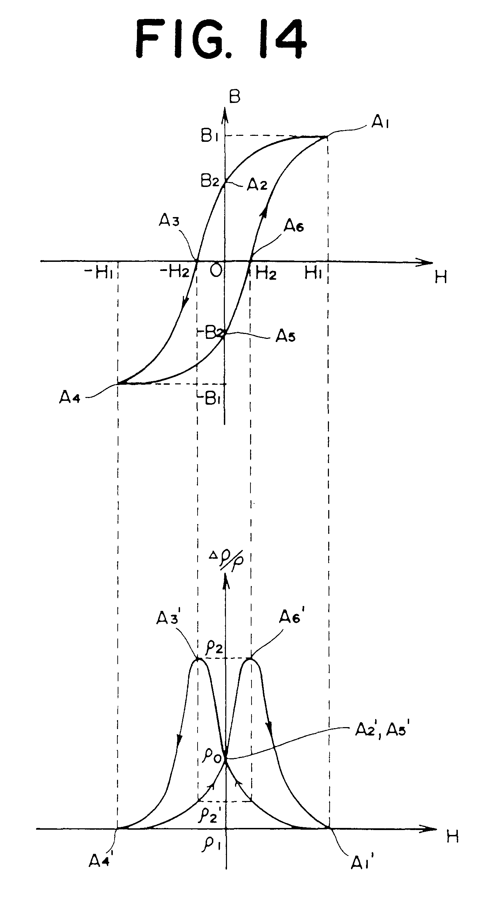

Hereinafter a description will be given on the principle of operation of a GMR element 6 produced as illustrated in Fig. 13 similarly to the aforementioned one in Fig. 3. As graphically shown in Fig. 14, the B-H characteristic of the GMR element 6 is substantially equal to that of the AMR element in Fig. 5. However, the Δρ/ρ-H characteristic of the GMR element 6 is one obtained by inverting the characteristic of Fig. 5 with respect to the axis of the MR ratio. Consequently, the relationship among the numerical values of the MR ratio is rendered reverse. That is, ρ₁ < ρ₂'< ρ₀ < ρ₂. Desired hysteresis characteristic is obtainable also in using the GMR element as shown in Fig. 14, so that it becomes possible to write and read the data in accordance with the principle of operation similar to the aforementioned one in Fig. 5.

Fig. 15A is a perspective view of a SOP (Small Outline Package) with partly broken away to show some components. The present invention is applicable to the SOP. The SOP comprises a resin body 34 where a memory chip (e.g., the substrate 20 shown in Fig. 10A) 36 is incorporated and leads 38 for connection to an external circuit. The memory chip 36 is connected to the leads 38 with bonding wires 40.

Fig. 15B is a perspective view of a SOJ (Small Outline J-bend Package) with partly broken away to show some components. The present invention is applicable to the SOJ. The SOJ comprises a resin body 42 where a memory chip (e.g., the substrate 20 shown in Fig. 10A) 44 is incorporated and J-bended leads 46 for connection to an external circuit. The memory chip 44 is connected to the J-bended leads 46 with bonding wires.

As described hereinabove, the present invention ensures advantageous effects of realizing a high-reliability magnetoresistive storage device of a simplified structure which is nonvolatile and usable at normal temperature with another advantage of reducing a write, read or overwrite time.

While specific embodiments of the present invention have been described in the foregoing description, the present invention is not limited to details of the embodiments. The scope of the present invention is defined in the appended claims, and all alterations and modifications which belong to the scope of equivalency of the claims shall be included in the scope of the present invention.

## Claims

1. A storage device comprising:
a magnetoresistive element (6, MR) presenting hysteresis characteristic in the relationship between a magnetic field (H) and a volume resistivity change rate (Δρ/ρ);
write means (2, 12, 14, 16, 18, INV, Q1-Q4, C) for applying, in response to input binary storage data indicative of change either a first state or a second state, a write magnetic field of a predetermined intensity in a first direction (H1) to said magnetoresistive element correspondingly to said first state, or applying said write magnetic field in a second direction (-H1), which is reverse to said first direction, to said magnetoresistive element correspondingly to said second state; **characterized by**
read means (8, 10, 12, 14, Q5, DEC, R) for applying to said magnetoresistive element a bias magnetic field (H2) which is lower in intensity than said write magnetic field (H1), and discriminating between said first and second states on the basis of the volume resistivity change rate of said magnetoresistive element.

2. The storage device according to claim 1, wherein the predetermined intensity of said write magnetic field is approximately equal to the intensity of a magnetic field required for saturating the magnetization of said magnetoresisitive element.

3. The storage device according to claim 1 or 2, wherein said bias magnetic field is set in such a manner as to maximize the difference between the volume resistivity change rate of said magnetoresistive element corresponding to said first state and the volume resistivity change rate of said element corresponding to said second state.

4. The storage device according to any of claims 1 to 3, wherein said bias magnetic field is applied in said first direction, and said read means discriminates said first or second state depending on whether the volume resisitivity change rate of said magnetoresistive element is relatively small or great.

5. The storage device according to any of claims 1 to 3, wherein said bias magnetic field is applied in said second direction, and said read means discriminates said first or second state depending on whether the volume resistivity change rate of said magnetoresistive element is relatively great or small.

6. The storage device according to any of claims 1 to 5, further comprising means for applying another magnetic field to said magnetoresistive element so that the storage data read out by the application of said bias magnetic field is written again.

7. The storage device according to any of claims 1 to 6, wherein said magnetoresistive element is shaped into a thin film and has an easy axis (EA) of magnetization and a hard axis (HA) of magnetization mutually orthogonal on the in-plane direction of said thin film;
said magnetoresistive element has a first plane (6A) and a second plane (6B) corresponding respectively to the obverse side and the reverse side thereof, and also has a first end portion (6C) and a second end portion (6D) corresponding respectively to both ends thereof;
said write means includes an upper current line (12) and a lower current line (2) opposed to said first plane and second plane respectively, means for causing a write current flow in said upper and lower current lines in mutually reverse directions, and means for deciding the direction of said write current flow in accordance with said first or second state;
said write magnetic field is applied substantially in parallel with said easy axis of magnetization;
said read means includes first and second terminals (8, 10) connected to said first and second end portions (6C, 6D) respectively, means for detecting the resistance value between said first and second terminals (8, 10), and means for causing a bias current flow, which is lower than said write current, in said upper and lower current lines (2, 12) in mutually reverse directions;
and said bias magnetic field is applied substantially in parallel with said easy axis (EA) of magnetization.

8. The storage device according to claim 7, wherein said upper current line is connected electrically to said lower current line in the vicinity of either of said first and second end portions (6C, 6D), and said upper and lower current lines are in series to said write current and bias current.

9. The storage device according to any of claims 1 to 6, wherein said magnetoresistive element is shaped into a thin film (6) and has an easy axis of magnetization and a hard axis of magnetization mutually orthogonal on the in-plane direction of said thin film;
said magnetoresistive element has a first plane (6A) and a second plane (6B) corresponding respectively to the obverse side and the reverse side thereof, and also has a first end portion (6C) and a second end portion (6D) corresponding respectively to both ends thereof;
said write means includes an upper current line (12) and a lower current line (2) opposed to said first plane and second plane respectively, means for causing a write current flow in said upper and lower current lines in mutually reverse directions, and means for deciding the direction of said write current flow in accordance with said first or second state;
said write magnetic field is applied substantially in parallel with said easy axis of magnetization;
said upper and lower current lines (2, 12) are connected to said first end portion (6C);
said read means includes a terminal (10) connected to said second end portion (6D), and means for causing a resistance detection current to flow between said terminal (10) and said upper current line (12);
and said bias magnetic field is applied substantially in parallel with said easy axis of magnetization by said resistance detection current.

10. The storage device according to claim 9, wherein a plurality of said magnetoresistive elements are employed, and bit lines (16) and word lines (18) are provided for arranging said elements in a matrix, said bit lines and word lines being connected to said upper current line (12) and lower current line (2) respectively.

11. The storage device according to any of claims 1 to 6, wherein said magnetoresistive element comprises a giant magnetoresistive element shaped into a thin film;
said element has a first plane (6A) and a second plane (6B) corresponding respectively to the obverse side and the reverse side thereof, and also has a first end portion (6C) and a second end portion (6D) corresponding respectively to both ends thereof;
said write means includes an upper current line (12) and a lower current line (2) opposed to said first plane and second plane respectively, means for causing a write current flow in said upper and lower current lines in mutually reverse directions, and means for deciding the direction of said write current flow in accordance with said first or second state;
said write magnetic field is applied substantially in parallel with the thin film in-plane direction of said magnetoresistive element;
said read means includes a first terminal (8) and a second terminal (10) connected to said first end portion (6C) and second end portion (6D) respectively, means for detecting the resistance value between said first and second terminals, and means for causing a bias current flow, which is smaller than said write current, in said upper and lower current lines in mutually reverse directions;
and said bias magnetic field is applied substantially in parallel with said write magnetic field.

12. The storage device according to claim 11, wherein said upper current line is connected electrically to said lower current line in the vicinity of either of said first and second end portions (6C, 6D), and said upper and lower current lines (12, 2) are in series to said write current and bias current.

13. The storage device according to any of claims 1 to 6, wherein said magnetoresistive element comprises a giant magnetoresistive element shaped into a thin film;
said element has a first plane (6A) and a second plane (6B) corresponding respectively to the obverse side and the reverse side thereof, and also has a first end portion (6C) and a second end portion (6D) corresponding respectively to both ends thereof;
said write means includes an upper current line (12) and a lower current line (2) opposed to said first plane and second plane respectively, means for causing a write current flow in said upper and lower current lines in mutually reverse directions, and means for deciding the direction of said write current flow in accordance with said first or second state;
said write magnetic field is applied substantially in parallel with the thin film in-plane direction of said magnetoresistive element;
said read means includes a terminal (10) connected to said second end portion (6D), and means for causing a resistance detection current to flow between said terminal (10) and said upper current line (12);
and said bias magnetic field is applied substantially in parallel with said write magnetic field by said resistance detection current.

14. The storage device according to claim 13, wherein a plurality of said magnetoresistive elements are employed and bit lines (16) and word lines (18) are provided for arraying said elements in a matrix, said bit lines and word lines being connected to said upper current line (12) and lower current line (2) respectively.

15. The storage device according to any of claims 1 to 14, wherein the storage device is incorporated in a memory card body (30).

16. The storage device according to any of claims 1 to 14, wherein the storage device is incorporated in a small outline package.

## Patentansprüche

1. Speichervorrichtung mit:
einem magnetoresistiven Element (6, MR), das eine Hysteresecharakteristik in der Beziehung zwischen einem Magnetfeld (H) und einer Veränderungsrate des spezifischen Volumenwiderstandes (Δρ/ρ) präsentiert;
einem Schreibmittel (2, 12, 14, 16, 18, INV, Q1-Q4, C) zum Anwenden, als Reaktion auf eingegebene binäre Speicherdaten, die entweder die Änderung eines ersten Zustands oder eines zweiten Zustands bezeichnen, eines Schreibmagnetfeldes mit vorbestimmter Intensität in einer ersten Richtung (H1) auf das magnetoresistive Element entsprechend dem ersten Zustand oder zum Anwenden des Schreibmagnetfeldes in einer zweiten Richtung (-H1), die zu der ersten Richtung entgegengesetzt ist, auf das magnetoresistive Element entsprechend dem zweiten Zustand; **gekennzeichnet durch**
ein Lesemittel (8, 10, 12, 14, Q5, DEC, R) zum Anwenden eines Vorspannungsmagnetfeldes (H2), dessen Intensität niedriger als jene des Schreibmagnetfeldes (H1) ist, auf das magnetoresistive Element und zum Unterscheiden zwischen den ersten und zweiten Zuständen auf der Basis der Veränderungsrate des spezifischen Volumenwiderstandes des magnetoresistiven Elementes.

2. Speichervorrichtung nach Anspruch 1, bei der die vorbestimmte Intensität des Schreibmagnetfeldes der Intensität eines Magnetfeldes, das zum Sättigen der Magnetisierung des magnetoresistiven Elementes erforderlich ist, etwa gleich ist.

3. Speichervorrichtung nach Anspruch 1 oder 2, bei der das Vorspannungsmagnetfeld auf solch eine Weise festgelegt ist, um die Differenz zwischen der Veränderungsrate des spezifischen Volumenwiderstandes des magnetoresistiven Elementes, die dem ersten Zustand entspricht, und der Veränderungsrate des spezifischen Volumenwiderstandes des Elementes, die dem zweiten Zustand entspricht, zu maximieren.

4. Speichervorrichtung nach irgendeinem der Ansprüche 1 bis 3, bei der das Vorspannungsmagnetfeld in der ersten Richtung angewendet wird und das Lesemittel den ersten oder den zweiten Zustand in Abhängigkeit davon unterscheidet, ob die Veränderungsrate des spezifischen Volumenwiderstandes des magnetoresistiven Elementes relativ klein oder groß ist.

5. Speichervorrichtung nach irgendeinem der Ansprüche 1 bis 3, bei der das Vorspannungsmagnetfeld in der zweiten Richtung angewendet wird und das Lesemittel den ersten oder den zweiten Zustand in Abhängigkeit davon unterscheidet, ob die Veränderungsrate des spezifischen Volumenwiderstandes des magnetoresistiven Elementes relativ groß oder klein ist.

6. Speichervorrichtung nach irgendeinem der Ansprüche 1 bis 5, ferner mit einem Mittel zum Anwenden eines anderen Magnetfeldes auf das magnetoresistive Element, so daß die Speicherdaten, die durch die Anwendung des Vorspannungsmagnetfeldes ausgelesen wurden, wieder geschrieben werden.

7. Speichervorrichtung nach irgendeinem der Ansprüche 1 bis 6, bei der das magnetoresistive Element in Form eines Dünnfilms gebildet ist und eine einfache Magnetisierungsachse (EA) und eine harte Magnetisierungsachse (HA) hat, die in der planaren Richtung des Dünnfilms zueinander orthogonal sind;
das magnetoresistive Element eine erste Ebene (6A) und eine zweite Ebene (6B) hat, die jeweilig seiner Vorderseite und seiner Rückseite entsprechen, und auch einen ersten Endabschnitt (6C) und einen zweiten Endabschnitt (6D) hat, die jeweilig seinen beiden Enden entsprechen;
das Schreibmittel eine obere Stromleitung (12) und eine untere Stromleitung (2) enthält, die der ersten Ebene bzw. der zweiten Ebene gegenüberliegen, ein Mittel zum Bewirken eines Schreibstromflusses in den oberen und unteren Stromleitungen in zueinander entgegengesetzten Richtungen und ein Mittel zum Bestimmen der Richtung des Schreibstromflusses gemäß dem ersten oder dem zweiten Zustand;
das Schreibmagnetfeld im wesentlichen parallel zu der einfachen Magnetisierungsachse angewendet wird;
das Lesemittel erste und zweite Anschlüsse (8, 10) enthält, die mit den jeweiligen ersten und zweiten Endabschnitten (6C, 6D) verbunden sind, ein Mittel zum Detektieren des Widerstandswertes zwischen den ersten und zweiten Anschlüssen (8, 10) und ein Mittel zum Bewirken des Fließens eines Vorspannungsstromes, der niedriger als der Schreibstrom ist, in den oberen und unteren Stromleitungen (2, 12) in zueinander entgegengesetzten Richtungen;
und das Vorspannungsmagnetfeld im wesentlichen parallel zu der einfachen Magnetisierungsachse (EA) angewendet wird.

8. Speichervorrichtung nach Anspruch 7, bei der die obere Stromleitung mit der unteren Stromleitung in der Nähe von einem der ersten und zweiten Endabschnitte (6C, 6D) elektrisch verbunden ist und die oberen und unteren Stromleitungen für den Schreibstrom und den Vorspannungsstrom seriell sind.

9. Speichervorrichtung nach irgendeinem der Ansprüche 1 bis 6, bei der das magnetoresistive Element in Form eines Dünnfilms (6) gebildet ist und eine einfache Magnetisierungsachse (EA) und eine harte Magnetisierungsachse (HA) hat, die in der planaren Richtung des Dünnfilms zueinander orthogonal sind;
das magnetoresistive Element eine erste Ebene (6A) und eine zweite Ebene (6B) hat, die jeweilig seiner Vorderseite und seiner Rückseite entsprechen, und auch einen ersten Endabschnitt (6C) und einen zweiten Endabschnitt (6D) hat, die jeweilig seinen beiden Enden entsprechen;
das Schreibmittel eine obere Stromleitung (12) und eine untere Stromleitung (2) enthält, die der ersten Ebene bzw. der zweiten Ebene gegenüberliegen, ein Mittel zum Bewirken eines Schreibstromflusses in den oberen und unteren Stromleitungen in zueinander entgegengesetzten Richtungen und ein Mittel zum Bestimmen der Richtung des Schreibstromflusses gemäß dem ersten oder dem zweiten Zustand;
das Schreibmagnetfeld im wesentlichen parallel zu der einfachen Magnetisierungsachse angewendet wird;
die oberen und unteren Stromleitungen (2, 12) mit dem ersten Endabschnitt (6C) verbunden sind;
das Lesemittel einen Anschluß (10) enthält, der mit dem zweiten Endabschnitt (6D) verbunden ist, und ein Mittel zum Bewirken des Fließens eines Widerstandsdetektionsstromes zwischen dem Anschluß (10) und der oberen Stromleitung (12);
und das Vorspannungsmagnetfeld im wesentlichen parallel zu der einfachen Magnetisierungsachse durch den Widerstandsdetektionsstrom angewendet wird.

10. Speichervorrichtung nach Anspruch 9, bei der eine Vielzahl der magnetoresistiven Elemente verwendet wird und Bitleitungen (16) und Wortleitungen (18) zum Anordnen der Elemente in einer Matrix vorgesehen sind, welche Bitleitungen und Wortleitungen mit der oberen Stromleitung (12) bzw. der unteren Stromleitung (2) verbunden sind.

11. Speichervorrichtung nach irgendeinem der Ansprüche 1 bis 6, bei der das magnetoresistive Element ein Element mit gigantischem magnetoresistiven Effekt umfaßt, das in Form eines Dünnfilms gebildet ist;
das Element eine erste Ebene (6A) und eine zweite Ebene (6B) hat, die jeweilig seiner Vorderseite und seiner Rückseite entsprechen, und ferner einen ersten Endabschnitt (6C) und einen zweiten Endabschnitt (6D) hat, die jeweilig seinen beiden Enden entsprechen;
das Schreibmittel eine obere Stromleitung (12) und eine untere Stromleitung (2) enthält, die der ersten Ebene bzw. der zweiten Ebene gegenüberliegen, ein Mittel zum Bewirken eines Schreibstromflusses in den oberen und unteren Stromleitungen in zueinander entgegengesetzten Richtungen und ein Mittel zum Bestimmen der Richtung des Schreibstromflusses gemäß dem ersten oder dem zweiten Zustand;
das Schreibmagnetfeld im wesentlichen parallel zu der planaren Richtung des Dünnfilms des magnetoresistiven Elementes angewendet wird;
das Lesemittel einen ersten Anschluß (8) und einen zweiten Anschluß (10) enthält, die mit dem ersten Endabschnitt (6C) bzw. dem zweiten Endabschnitt (6D) verbunden sind, ein Mittel zum Detektieren des Widerstandswertes zwischen den ersten und zweiten Anschlüssen und ein Mittel zum Bewirken des Fließens eines Vorspannungsstromes, der kleiner als der Schreibstrom ist, in den oberen und unteren Stromleitungen in zueinander entgegengesetzten Richtungen;
und das Vorspannungsmagnetfeld im wesentlichen parallel zu dem Schreibmagnetfeld angewendet wird.

12. Speichervorrichtung nach Anspruch 11, bei der die obere Stromleitung mit der unteren Stromleitung in der Nähe von einem der ersten und zweiten Endabschnitte (6C, 6D) elektrisch verbunden ist und die oberen und unteren Stromleitungen (12, 2) für den Schreibstrom und den Vorspannungsstrom seriell sind.

13. Speichervorrichtung nach irgendeinem der Ansprüche 1 bis 6, bei der das magnetoresistive Element ein Element mit gigantischem magnetoresistiven Effekt umfaßt, das in Form eines Dünnfilms gebildet ist;
das Element eine erste Ebene (6A) und eine zweite Ebene (6B) hat, die jeweilig seiner Vorderseite und seiner Rückseite entsprechen, und ferner einen ersten Endabschnitt (6C) und einen zweiten Endabschnitt (6D) hat, die jeweilig seinen beiden Enden entsprechen;
das Schreibmittel eine obere Stromleitung (12) und eine untere Stromleitung (2) enthält, die der ersten Ebene bzw. der zweiten Ebene gegenüberliegen, ein Mittel zum Bewirken eines Schreibstromflusses in den oberen und unteren Stromleitungen in zueinander entgegengesetzten Richtungen und ein Mittel zum Bestimmen der Richtung des Schreibstromflusses gemäß dem ersten oder dem zweiten Zustand;
das Schreibmagnetfeld im wesentlichen parallel zu der planaren Richtung des Dünnfilms des magnetoresistiven Elementes angewendet wird;
das Lesemittel einen Anschluß (10) enthält, der mit dem zweiten Endabschnitt (6D) verbunden ist, und ein Mittel zum Bewirken des Fließens eines Widerstandsdetektionsstromes zwischen dem Anschluß (10) und der oberen Stromleitung (12);
und das Vorspannungsmagnetfeld im wesentlichen parallel zu dem Schreibmagnetfeld durch den Widerstandsdetektionsstrom angewendet wird.

14. Speichervorrichtung nach Anspruch 13, bei der eine Vielzahl der magnetoresistiven Elemente verwendet wird und Bitleitungen (16) und Wortleitungen (18) zum Anordnen der Elemente in einer Matrix vorgesehen sind, welche Bitleitungen und Wortleitungen mit der oberen Stromleitung (12) bzw. der unteren Stromleitung (2) verbunden sind.

15. Speichervorrichtung nach irgendeinem der Ansprüche 1 bis 14, welche Speichervorrichtung in einem Speicherkartenkörper (30) inkorporiert ist.

16. Speichervorrichtung nach irgendeinem der Ansprüche 1 bis 14, welche Speichervorrichtung in einer kleinen Pakkung (small outline package) inkorporiert ist.

## Revendications

1. Dispositif de stockage comprenant :
un élément magnéto-résistif (6, MR) qui présente une caractéristique d'hystérésis dans la relation entre le champ magnétique (H) et le taux de variation de la résistivité volumique (Δρ/ρ) ;
un moyen d'écriture (2, 12, 14, 16, 18, INV, Q1-Q4, C) servant, en réponse à des données de stockage binaires d'entrée indicatives de changement d'un premier état ou d'un deuxième état, à appliquer un champ magnétique d'écriture d'une intensité prédéterminée suivant un premier sens (H1) audit élément magnéto-résistif en correspondance avec le premier état, ou à appliquer ledit champ magnétique d'écriture suivant un deuxième sens (-H1), inverse dudit premier sens, audit élément magnéto-résistif en correspondance avec ledit deuxième état ;
**caractérisé par** :
un moyen de lecture (8, 10, 12, 14, Q5, DEC, R) servant à appliquer audit élément magnéto-résistif un champ magnétique de polarisation (H2) dont l'intensité est inférieure à celle dudit champ magnétique d'écriture (H1), et à distinguer entre lesdits premier et deuxième états sur la base du taux de variation de résistivité volumique dudit élément magnéto-résistif.

2. Dispositif de stockage selon la revendication 1, où l'intensité prédéterminée dudit champ magnétique d'écriture est approximativement égale à l'intensité du champ magnétique nécessaire pour saturer l'aimantation dudit élément magnéto-résistif.

3. Dispositif de stockage selon la revendication 1 ou 2, où ledit champ magnétique de polarisation est fixé de manière à maximiser la différence entre le taux de variation de résistivité volumique dudit élément magnéto-résistif correspondant audit premier état et le taux de variation de résistivité volumique dudit élément correspondant audit deuxième état.

4. Dispositif de stockage selon l'une quelconque des revendications 1 à 3, où ledit champ magnétique de polarisation est appliqué suivant ledit premier sens, et ledit moyen de lecture distingue entre lesdits premier et deuxième états en fonction du fait que le taux de variation de résistivité volumique dudit élément magnéto-résistif est relativement petit ou grand.

5. Dispositif de stockage selon l'une quelconque des revendications 1 à 3, où ledit champ magnétique de polarisation est appliqué dans ledit deuxième sens, et ledit moyen de lecture distingue entre lesdits premier et deuxième états en fonction du fait que le taux de variation de résistivité volumique dudit élément magnéto-résistif est relativement grand ou petit.

6. Dispositif de stockage selon l'une quelconque des revendications 1 à 5, comprenant en outre un moyen qui sert à appliquer un autre champ magnétique audit élément magnéto-résistif de façon que les données de stockage lues par application dudit champ magnétique de polarisation soient écrites de nouveau.

7. Dispositif de stockage selon l'une quelconque des revendications 1 à 6, où ledit élément magnéto-résistif est conformé en une pellicule mince et possède un axe d'aimantation facile (EA) et un axe d'aimantation difficile (HA) mutuellement perpendiculaire sur la direction dans le plan de ladite pellicule mince ;
ledit élément magnéto-résistif possède un premier plan (6A) et un deuxième plan (6B) qui correspondent respectivement à son côté de face et à son côté inverse, et possède également une première partie terminale (6C) et une deuxième partie terminale (6D) qui correspondent respectivement à ses deux extrémités ;
ledit moyen d'écriture comporte une ligne de courant supérieure (12) et une ligne de courant inférieure (2) respectivement en regard dudit premier plan et dudit deuxième plan, un moyen provoquant la circulation d'un courant d'écriture dans lesdites lignes de courant supérieure et inférieure dans des sens mutuellement inverses, et un moyen qui décide du sens de ladite circulation du courant d'écriture en fonction dudit premier ou dudit deuxième état ;
ledit champ magnétique d'écriture est appliqué sensiblement parallèlement audit axe d'aimantation facile ;
ledit moyen de lecture comporte des première et deuxième bornes (8, 10) respectivement connectées auxdites première et deuxième parties terminales (6C, 6D), un moyen servant à détecter la valeur de résistance existant entre lesdites première et deuxième bornes (8, 10) et un moyen qui provoque la circulation d'un courant de polarisation, lequel est inférieur audit courant d'écriture, dans lesdites lignes de courant supérieure et inférieure (2, 12), dans des sens mutuellement inverses ; et
ledit champ magnétique de polarisation est appliqué sensiblement parallèlement audit axe d'aimantation facile (EA).

8. Dispositif de stockage selon la revendication 7, où ladite ligne de courant supérieure est électriquement connectée à ladite ligne de courant inférieure au voisinage de l'une ou l'autre desdites première et deuxième parties terminales (6C, 6D), et lesdites lignes de courant supérieure et inférieure sont en série pour ledit courant d'écriture et ledit courant de polarisation.

9. Dispositif de stockage selon l'une quelconque des revendications 1 à 6, où ledit élément magnéto-résistif est conformé en une pellicule mince (6) et possède un axe d'aimantation facile et un axe d'aimantation difficile qui sont mutuellement perpendiculaires sur la direction dans la plan de ladite pellicule mince ;
ledit élément magnéto-résistif possède un premier plan (6A) et un deuxième plan (6B) qui correspondent respectivement à son côté de face et à son côté inverse, et possède également une première partie terminale (10C) et une deuxième partie terminale (10D) qui correspondent respectivement à ses deux extrémités ;
ledit moyen d'écriture comporte une ligne de courant supérieure (12) et une ligne de courant inférieure (2) situées respectivement en regard dudit premier plan et dudit deuxième plan, un moyen qui provoque la circulation d'un courant d'écriture dans lesdites lignes de courant supérieure et inférieure dans des sens mutuellement inverses, et un moyen qui décide du sens de ladite circulation du courant d'écriture en fonction dudit premier ou dudit deuxième état ;
ledit champ magnétique d'écriture est appliqué sensiblement parallèlement audit axe d'aimantation facile ;
lesdites lignes de courant supérieure et inférieure (2, 12) sont connectées à ladite première partie terminale (6C) ;
ledit moyen de lecture comporte une borne (10) connectée à ladite deuxième partie terminale (6D), et un moyen qui fait circuler un courant de détection de valeur de résistance entre ladite borne (10) et ladite ligne de courant supérieure (12) ; et
ledit champ magnétique de polarisation est appliqué sensiblement parallèlement audit axe d'aimantation facile par ledit courant de détection de valeur de résistance.

10. Dispositif de stockage selon la revendication 9, où une pluralité desdits éléments magnéto-résistifs est employée, tandis que des lignes de bit (16) et des lignes de mot (18) sont prévues afin de disposer lesdits éléments en une matrice, lesdites lignes de bit et lesdites lignes de mot étant connectées respectivement à ladite ligne de courant supérieure (12) et à ladite ligne de courant inférieure (2).

11. Dispositif de stockage selon l'une quelconque des revendications 1 à 6, où ledit élément magnéto-résistif comprend un élément magnéto-résistif géant conformé en une pellicule mince ;
ledit élément possède un premier plan (6A) et un deuxième plan (6B) qui correspondent respectivement à son côté de face et à son côté inverse, et possède également une première partie terminale (6C) et une deuxième partie terminale (6D) qui correspondent respectivement à ses deux extrémités ;
ledit moyen d'écriture comporte une ligne de courant supérieure (12) et une ligne de courant inférieure (2) situées respectivement en regard dudit premier plan et dudit deuxième plan, un moyen qui provoque la circulation d'un courant d'écriture dans lesdites lignes de courant supérieure et inférieure suivant des sens mutuellement inverses, et un moyen qui décide du sens de ladite circulation du courant d'écriture en fonction dudit premier état ou dudit deuxième état ;
ledit champ magnétique d'écriture est appliqué sensiblement parallèlement à la direction dans le plan de la pellicule mince dudit élément magnéto-résistif ;
ledit moyen de lecture comporte une première borne (8) et une deuxième borne (10) respectivement connectées à ladite première partie terminale (6C) et à ladite deuxième partie terminale (6D), un moyen servant à détecter la valeur de résistance qui existe entre lesdites première et deuxième bornes, et un moyen qui provoque la circulation d'un courant de polarisation, lequel est plus petit que ledit courant d'écriture, dans lesdites lignes de courant supérieure et inférieure suivant des sens mutuellement inverses ; et
ledit champ magnétique de polarisation est appliqué sensiblement parallèlement audit champ magnétique d'écriture.

12. Dispositif de stockage selon la revendication 11, où ladite ligne de courant supérieure est connectée électriquement à ladite ligne de courant inférieure au voisinage de l'une ou l'autre desdites première et deuxième parties terminales (6C, 6D), et lesdites lignes de courant supérieure et inférieure (12, 2) sont en série pour ledit courant d'écriture et ledit courant de polarisation.

13. Dispositif de stockage selon l'une quelconque des revendications 1 à 6, où ledit élément magnéto-résistif comprend un élément magnéto-résistif géant conformé en une pellicule mince ;
ledit élément possède un premier plan (6A) et un deuxième plan (6B) qui correspondent respectivement à son côté de face et à son côté inverse, et possède également une première partie terminale (6C) et une deuxième partie terminale (6D) qui correspondent respectivement à ses deux extrémités ;
ledit moyen d'écriture comporte une ligne de courant supérieure (12) et une ligne de courant inférieure (2) respectivement situées en regard dudit premier plan et dudit deuxième plan, un moyen qui provoque la circulation d'un courant d'écriture dans lesdites lignes de courant supérieure et inférieure suivant des sens mutuellement inverses, et un moyen qui décide du sens de ladite circulation du courant d'écriture en fonction dudit premier état ou dudit deuxième état ;
ledit champ magnétique d'écriture est appliqué sensiblement parallèlement à la direction dans le plan de la pellicule mince dudit élément magnéto-résistif ;
ledit moyen de lecture comporte une borne (10) connectée à ladite deuxième partie terminale (6D), et un moyen qui fait circuler un courant de détection de valeur de résistance entre ladite borne (10) et ladite ligne de courant supérieure (12) ; et
ledit champ magnétique de polarisation est appliqué sensiblement parallèlement audit champ magnétique d'écriture par ledit courant de détection de valeur de résistance.

14. Dispositif de stockage selon la revendication 13, où une pluralité desdits éléments magnéto-résistifs sont employés, et des lignes de bit (16) et des lignes de mots (18) sont prévues pour disposer lesdits éléments suivant une matrice, lesdites lignes de bit et lesdites lignes de mot étant respectivement connectées à la ligne de courant supérieure (12) et à la ligne de courant inférieure (2).

15. Dispositif de stockage selon l'une quelconque des revendications 1 à 14, où le dispositif de stockage est incorporé dans un corps de carte de mémoire (30).

16. Dispositif de stockage selon l'une quelconque des revendications 1 à 14, où le dispositif de stockage est incorporé dans un boîtier du type dit de faible encombrement.
